# EUROPÄISCHE PATENTSCHRIFT

(11) **EP 2 834 601 B1**
(45) Veröffentlichungstag und Bekanntmachung des Hinweises auf die Patenterteilung: **01.06.2016**
(21) Anmeldenummer: 13713434.2
(22) Anmeldetag: 28.03.2013
(51) Int. Cl.: G01D 5/20, G01D 5/22, G01D 5/245, G01R 1/12

(54) **VERFAHREN UND ANORDNUNG ZUR POSITIONSBESTIMMUNG EINES BAUTEILS**
METHOD AND ARRANGEMENT FOR DETERMINING THE POSITION OF A COMPONENT
PROCÉDÉ ET ENSEMBLE POUR DÉTERMINER LA POSITION D'UN COMPOSANT

(30) Priorität: 02.04.2012 DE 102012102855
(43) Veröffentlichungstag der Anmeldung: 11.02.2015
(73) Patentinhaber: ASG Luftfahrttechnik und Sensorik GmbH, 69469 Weinheim (DE)
(72) Erfinder: STRIETZEL, Reiner, 69123 Heidelberg (DE)
(74) Vertreter: Stoffregen, Hans-Herbert
(86) Internationale Anmeldenummer: PCT/EP2013/056748
(87) Internationale Veröffentlichungsnummer: WO 2013/149949

(56) Entgegenhaltungen:
- EP-A1- 0 805 339
- EP-A2- 1 713 160
- DE-A1- 19 803 249
- US-A- 6 011 389
- US-A1- 2008 178 665

## Beschreibung

Die Erfindung bezieht sich auf ein Verfahren nach dem Oberbegriff des Anspruchs 1 sowie auf eine Anordnung zur Positionsbestimmung nach dem Oberbegriff des Anspruchs 6.

Ein Verfahren und eine Anordnung zur Positionsbestimmung eines Bauteils ist in der EP 1 713 160 A2 beschrieben. Eine Position eines Rotors in Bezug zu einem Chassis wird mittels einer Anordnung bestimmt. Die Anordnung umfasst einen mit dem Chassis verbundenen ersten Sensor zur Erfassung einer auf einer metallischen Oberfläche des Rotors ausgebildeten ersten abtastbaren Struktur bei einer Relativbewegung zwischen dem Rotor und dem ersten Sensor. Der erste Sensor ist als Differentialtransformator mit einer Primärwicklung und zwei Sekundärwicklungen ausgebildet. Diese sind so verschaltet, dass sich als ihr jeweiliges Ausgangssignal unmittelbar die Differenz der Signale der zusammengehörigen Sekundärwicklungen ergibt, so dass die von der Primärwicklung in den Sekundärwicklungen erzeugten Spannungen sich bei symmetrischer magnetischer Kopplung der Wicklungen gegenseitig aufheben. Die abtastbare Struktur der metallischen Oberfläche des Rotors ist in Form von Zähnen/Lücken mit unterschiedlicher Permeabilität oder magnetischer Eigenschaft derart ausgebildet, dass sich die magnetische Kopplung der Wicklungen bei der Relativbewegung des Differentialtransformators entlang der Messtruktur verändert, wodurch am Ausgang des Differentialtransformators ein kontinuierliches Signal anliegt, dessen Größe ein Maß für die Asymmetrie ist. Aus dem Verlauf des kontinuierlichen, inkrementellen Signals ist die relative Position des Rotors bestimmbar.

In der DE 198 03 249 A1 ist ein induktiver Absolutpositionswandler beschrieben. Der induktive Absolutpositionswandler umfasst ein Skalenelement sowie ein Lesekopfelement, wobei das Skalenelement und das Lesekopfelement relativ zueinander entlang einer Messachse beweglich sind. Ferner ist ein induktiver Codespur-Positionswandler vorgesehen, der eine an dem Lesekopfelement ausgebildete Codespur-Sendewicklung und mindestens einen Satz an dem Lesekopfelement ausgebildeter Codespur-Empfängerwicklungen aufweist. Ferner ist eine an dem Element ausgebildete Codespur vorgesehen, die eine Mehrzahl von entlang der Messachse verteilten Flussmodulatorzonen aufweist, wobei in mindestens einigen dieser Flussmodulatorzonen mindestens ein Flussmodulator vorhanden ist. Dabei sind die Flussmodulatoren als Kurzschlussspulen in einer gedruckten Schaltung ausgebildet.

Die EP 0 805 339 A1 beschreibt eine Vorrichtung für die Erfassung der Position und/oder der Bewegung eines Teils, das sich relativ zu der Vorrichtung verlagern kann und Zonen mit geringer magnetischer Permeabilität sowie Zonen mit hoher magnetischer Permeabilität, die ein Magnetfeld beeinflussen, besitzt. Die Vorrichtung umfasst wenigstens eine Primärwicklung, die ein Magnetfeld induziert und wenigstens ein paar Sekundärwicklungen, die das Magnetfeld empfangen. Die Wicklungen sind im Wesentlichen parallel zu der Ebene des Teils und gegenüber den Zonen angeordnet, wobei die Sekundärwicklungen voneinander verschieden und in einer differentiellen Struktur in Bezug auf die Primärwicklung angeordnet sind.

Die US 6,011,389 B offenbart ein induktives Transducersystem zur Verwendung in Linear- oder Rotationsencodern. Dabei ist vorgesehen, dass ein erstes, aktives Mittel Wirbelströme in einem zweiten, passiven Mittel induziert. Das erste, aktive Mittel umfasst sowohl einen Transmitter zur Erzeugung eines magnetischen Feldes als auch einen Empfänger zum Empfang des Feldes. Der Empfänger umfasst eine Vielzahl von symmetrischen Wicklungen.

Die US 2008/0178665 A1 beschreibt eine Vorrichtung zur Messung der Position eines Kolbens in einem Zylinder, der sich entlang einer Achse erstreckt, Die Vorrichtung besteht aus zumindest zwei Positionssensoren, die jeweils ein erstes Sensormittel umfassen, welches mit dem Kolben verbunden ist, sowie ein zweites Sensormittel, welches mit dem Zylinder verbunden ist.

In der US 7,652,469 B2 ist ein induktiver Positionssensor beschrieben, mit einem räumlich periodischen Maßstab mit einer Serie von leitenden oder permeablen Eigenschaften im Abstand T und einem Lesekopf mit aktiven Wicklungen und sensorischen Wicklungen, die gegenüberliegend des Maßstabs mit einer räumlichen Periode 2T entlang des Maßstabs angeordnet sind. Die Wicklungen sind jeweils unterteilt in zwei identische Wicklungselemente, mit derselben relativen Anordnung innerhalb zweier identischer Wicklungselementemuster mit einem Mitte-zu-Mitte Abstand entlang des Maßstabs von NT + T/2, wobei die Wicklungen derart miteinander verbunden sind, dass die Polaritäten der Wicklungselemente in jeder Wicklung entweder entgegengesetzt für aktive Wicklungen und gleichgerichtet für sensitive Wicklungen sind.

Die US 7,667,455 B2 bezieht sich auf einen magnetischen, ringförmigen Encoder, umfassend eine Vielzahl von magnetischen Süd-Polen und magnetischen Nord-Polen, die abwechselnd in einem Anordnungsmuster angeordnet sind. Hierbei wird ebenfalls ein differentielles Messverfahren eingesetzt, wobei als Magnetflusssensor ein Differentialtransformator verwendet wird.

Die US 8,004,277 B2 bezieht sich auf einen Winkelpositionssensor zur Bestimmung einer Winkelposition, umfassend einen Bolzen mit einem Gewindeabschnitt und einer Struktur zum Eingriff einer externen Anordnung. Der Bolzen umfasst einen ersten Permanentmagneten. Ferner ist eine Mutter auf den Gewindeabschnitt aufgeschraubt, die aus einem ersten magnetisch permeablen Material ausgebildet ist oder einen zweiten Permanentmagneten enthält. Mit der Mutter ist zumindest ein Anschlag gekoppelt, um eine Drehbewegung der Schraube zu vermeiden und um eine Linearbewegung der Schraube zu ermöglichen, wenn sich der Bolzen dreht. Ferner ist ein erster magnetischer Sensor entlang einer Länge des Gewindeabschnitts positioniert, um die lineare Position der Mutter zu messen. Ein zweiter Magnetsensor ist zur Messung einer Winkelposition des Bolzens vorgesehen. Ferner ist ein Signalverarbeitungsschaltkreis mit dem ersten magnetischen Sensor und dem zweiten magnetischen Sensor verbunden, um Parameter betreffend eine Winkelposition des rotierenden Teils zu bestimmen.

Die US 6,011,389 A bezieht sich auf einen strominduzierenden Positionstransducer mit einem elektronischen Schaltkreis geringer Leistung. Die beschriebene Sensoranordnung ist als Differentialtransformator ausgebildet. Auch dürfte zumindest eine Transformatorwicklung als Primärwicklung und eine weitere Wicklung als Sekundärwicklung ausgebildet sein.

Aus der DE 102 48 142 B3 ist ein Verfahren zur Herstellung einer magnetisch abtastbaren Codierung in einem metallischen Bauelement sowie ein metallisches Bauelement mit einer entsprechenden magnetisch abtastbaren Codierung bekannt. Die Codierung besteht aus Code-Elementen, die dadurch erzeugt werden, dass in dem Bauelement bleibende Gefügeveränderungen mit einer magnetischen Leitfähigkeit erzeugt werden, die von derjenigen des unbehandelten Materials des Bauelementes abweicht. Auch ist beschrieben, wie die Code-Elemente ausgelesen werden. Dabei wird das Bauteil relativ zu dem Magnetfeldsensor bewegt, wobei dieser die unterschiedlichen magnetischen Eigenschaften bzw. Magnetflussänderungen zwischen den Code-Elementen und dem diese umgebenden Material erfasst. Auf diese Weise können die Code-Elemente zur Identifizierung oder Lagebestimmung des Bauteils erfasst werden.

Bei dem bekannten Sensor handelt es sich um einen Magnetfeldsensor mit einer einzigen Spule, was in der Praxis zu Ungenauigkeiten führen kann.

Davon ausgehend liegt der vorliegenden Erfindung die Aufgabe zu Grunde, ein Verfahren und eine Anordnung der einganges genannten Art derart weiterzubilden, dass die Genauigkeit der Positionsbestimmung verbessert wird.

Die Aufgabe wird erfindungsgemäß durch die Merkmale des Anspruchs 1 gelöst. Das Verfahren ist als ein differentielles Messverfahren ausgeführt, wobei als Magnetflusssensor ein Differentialtransformater mit einer Primärwicklung und zwei Sekundärwicklungen verwendet wird. Dabei wird die Primärwicklung mit Wechselspannung erregt, so dass an den Sekundärwicklungen ein Differenzsignal als Ausgangssignal abgegriffen werden kann. Die durch Gefügeänderungen, wie z. B. selektives Härten in die metallische Oberfläche des Bauteils eingebrachten, magnetisch abtastbaren Strukturen wie Messsteifen lassen sich durch unterschiedliche physikalische Methoden erfassen. Insbesondere kann die magnetische Permeabilitätsänderung, wie Wirbelstromverluste oder andere Verfahren benutzt werden, um die bewusst eingebrachten Gefugeänderungen zu detektieren. In diesem Zusammenhang hat sich gemäß der Erfindung ein differentielles Messverfahren als besonders geeignet erwiesen, da hierdurch ein kontinuierliches Messen ermöglicht wird und Störeffekte eliminiert werden können.

Um eine besonders hohe Genauigkeit zu erreichen ist vorgesehen, dass als erste magnetisch abtastbare Struktur magnetisch abtastbare Messstreifen verwendet werden, welche als Bestandteile eines Maßstabes vorzugsweise äquidistant entlang Längsachse des ersten Bauteils quer zu der Längsachse verlaufen und dass bei der Relativbewegung der Messstreifen ein kontinuierliches Sinus-Signal oder Kosinus-Signal erzeugt wird.

Die Primärwicklung des Differentialtransformators wird dabei mit Wechselspannung erregt und die Sekundärwicklungen werden vorzugsweise phasengleich verschaltet. Dadurch wird erreicht, dass alle gleichen Signale eliminiert werden. Als Ausgangssignale treten somit nur Differenzsignale auf. Verfährt ein so gestalteter Sensorkopf entlang eines Maßstabes aus äquidistant angebrachten Messstreifen, so ist das Ausgangssignal kontinuierlich sinusförmig und sehr stabil, so dass eine sehr hohe Auflösung realisiert werden kann.

Es ist vorgesehen, dass die Position des ersten Bauteils in Bezug zu dem zweiten Bauteil absolut bestimmt wird, wobei eine auf der Oberfläche des ersten Bauteils angeordnete zweite magnetisch abtastbare Struktur mittels zumindest eines mit dem zweiten Bauteil verbundenen zweiten Magnetflusssensor erfasst wird und dass als zweite magnetisch abtastbare Struktur vorzugsweise zwei magnetisch abtastbare Messstreifen verwendet werden, welche entlang der Längsachse V-förmig und symmetrisch zu der Längsachse des Bauteils verlaufen.
Betrachtet man z. B. einen Leerraum und einen Messstreifen des oben genannten Maßstabes als Sektoren, so wird zur Absolutwertmessung ein sogenannter Sektorpointer vorgeschlagen. Dieser wird gemäß der Erfindung durch die zweite Messstreifenanordnung in Form eines Längenmesssystems realisiert, welches im Vergleich zu dem ersten Maßstab eine wesentlich geringere Auflösung benötigt.
Die zweite Messstreifenanordnung kann mit demselben Differentialtransformator als Magnetflusssensor abgetastet werden, und zwar für lange Wege, jedoch mit geringerer Auflösung. Vorzugsweise sind die Messstreifen als sich in Längsrichtung schräg erstreckende, selektiv gehärtete Streifen auf der metallischen Oberfläche des Bauteils ausgebildet.
Eine weitere bevorzugte Verfahrensweise zeichnet sich dadurch aus, dass die Messstreifen bei linearer Bewegung des Bauteils quer zu einer Sensorfläche des zweiten Magnetflusssensors entlang der Sensorfläche bewegt werden, so dass in dem zweiten Magnetflusssensor ein von der Position des ersten Bauteils abhängiges kontinuierliches Ausgangssignal erzeugt wird. Somit kann aus der Signalfolge des ersten Magnetflusssensors und dem kontinuierlichen Ausgangssignal des zweiten Magnetflusssensors die absolute Position des ersten Bauteils bestimmt werden. Zur weiteren Verbesserung der Auflösung wird vorgeschlagen, dass zumindest zwei der ersten Magnetflusssensoren räumlich so versetzt zueinander angeordnet werden, dass ein vorderer erster Magnetflusssensor bei linearer Bewegung des Bauteils ein Sinus-Signal und ein hinterer erster Magnetflusssensor ein Cosinus-Signal erzeugt.

Des Weiteren bezieht sich die Erfindung auf eine Anordnung zur Bestimmung einer Position eines ersten Bauteils wie Kolbenstange in Bezug zu einem zweiten Bauteil wie Hydraulik- oder Pneumatikzylinder, umfassend zumindest einen mit dem zweiten Bauteil verbundenen ersten Magnetflusssensor zur Erfassung einer auf einer Oberfläche des ersten Bauteils ausgebildeten ersten magnetisch abtastbare Struktur wie Messsteifen bei einer Relativbewegung zwischen dem ersten Bauteil und dem Magnetflusssensor. Diese Anordnung zeichnet sich durch die Merkmale des Anspruchs 6 aus. Der zumindest eine erste Magnetflusssensor ist als Differentialtransformator ausgebildet.
Der Differentialtransformator umfasst eine Primärwicklung sowie zwei Sekundärwicklungen, wobei die Primärwicklung mit einem Wcchselspannungsgenerator verbunden ist und wobei die beiden Sekundärwicklungen vorzugsweise phasengleich verschaltet und mit einer Auswerteinheit verbunden sind.

Das System zur Messung der absoluten Position des Bauteils weist einen zweiten Magnetflusssensor auf, welcher eine zweite, vorzugsweise entlang einer Längsachse des Bauteils verlaufende magnetisch abtastbare Messstreifenstruktur erfasst, wobei die zweite magnetisch abtastbare Messsteifenanordnung vorzugsweise V-förmige entlang der Längsachse verlaufende Messstreifen umfasst, die bei linearer Bewegung des Bauteils eine Sensorfläche des zweiten Magnetflusssensors überqueren. Eine bevorzugte Ausführungsform der Anordnung zeichnet sich dadurch aus, dass Primär- und Sekundärwicklungen des Differenzialtransformators als in einer Ebene angeordnete Induktivitäten ausgebildet und zur Bildung einer Sensorfläche auf einem Träger derart nebeneinander angeordnet sind, wobei deren magnetische Achsen parallel zueinander verlaufen. Dabei ist die Induktivität als SMD (Surface Mounted Device)-Induktivität oder Miniatur-Induktivität ausgebildet.
Gemäß einer weiteren bevorzugten Ausführungsform ist vorgesehen, dass die Anordnung ein hydraulischer, elektrischer, pneumatischer oder anderer Antrieb ist, wobei das erste Bauteil als eine Kolbenstange und wobei das zweite Bauteil als ein hydraulischer, elektrischer, pneumatischer oder anderer Zylinder ausgebildet ist, in dem die Kolbenstange längsbeweglich verschiebbar ist.
Bei dieser Ausführungsform kann der Magnetflusssensor an einem innenliegenden Rand eines an dem Hydraulik- oder Pneumatikzylinder angeordneten Sensorhalters angrenzend an die Oberfläche der Kolbenstange zum Erfassen der Messstreifenanordnung angeordnet ist. Vorzugsweise ist der Sensorhalter als ein stirnseitig mit dem Zylinder verbundener Sensorring ausgebildet.
Zur absoluten Positionsbestimmung ist vorgesehen, dass die erste und zweite magnetisch abtastbare Messstreifenanordnung auf diametral gegenüberliegenden Oberflächen der Kolbenstange ausgebildet sind und dass der erste und zweite Magnetflusssensor an diametral gegenüberliegenden Positionen des stirnseitig umlaufenden Sensorhalters angeordnet sind, wobei der erste und zweite Magnetflusssensor jeweils in einer Aussparung einer Innenfläche des Sensorhalters angeordnet sind.
Eine noch höhere Auflösung wird dadurch erreicht, dass mehrere erste oder zweite Magnetflusssensoren vorgesehen sind, die räumlich so versetzt sind, dass bei linearer Bewegung des ersten Bauteils ein Sinus- und ein Cosinus-Signal als Ausgangssignal erzeugt wird.

Im Rahmen der Erfindung kann ein Sensor zur Erfassung einer auf einer metallischen Oberfläche eines Bauteils ausgebildeten magnetisch abtastbaren Messstreifenstruktur bei einer Relativbewegung zwischen dem Sensor und dem Bauteil Verwendung finden, wobei der Sensor zumindest eine Transformatorwicklung umfasst. Der Sensor ist als Differentialtransformator ausgebildet. Dieser umfasst zumindest eine Transformatorwicklung als Primärwicklung und zwei weitere Wicklungen als Sekundärwicklungen, wobei die Primär- und Sekundärwicklungen als SMD-Induktivitäten oder Miniatur-Induktivitäten ausgebildet sein können und magnetisch gekoppelt flächig auf einem Träger angeordnet sind.

Vorzugsweise weisen die SMD-Induktivitäten jeweils eine magnetische Achse auf und sind derart nebeneinander angeordnet, dass die magnetischen Achsen parallel zueinander verlaufen.

Weitere Einzelheiten, Vorteile und Merkmale der Erfindung ergeben sich nicht nur aus den Ansprüchen, den diesen zu entnehmenden Merkmalen - für sich und/oder in Kombination-, sondern auch aus der nachfolgenden Beschreibung eines der Zeichnung zu entnehmenden bevorzugten Ausführungsbeispielen.

Es zeigen:
- Fig. 1a: eine Draufsicht eines hydraulischen Antriebs mit Hydraulikzylinder und Kolbenstange,
- Fig. 1b: eine Unteransicht des Hydraulikantriebs mit Hydraulikzylinder und Kolbenstange,
- Fig. 2: ein Schaltbild eines als Differenzialtransformator aufgebauten Magnetflusssensors,
- Fig. 3: eine schematische Darstellung eines Sensorkopfes des Magnetflusssensors in Bezug zu einer magnetisch abtastbaren Messstreifen der Kolbenstange,
- Fig. 4: eine schematische Darstellung eines in Längsrichtung der Kolbenstange verlaufenden Messstreifens und eines Sensorkopfes in verschiedenen Positionen,
- Fig. 5a: eine Vorderansicht eines Sensorrings zur Aufnahme der Magnetflusssensoren und
- Fig. 5b: eine Schnittdarstellung des Sensorrings.

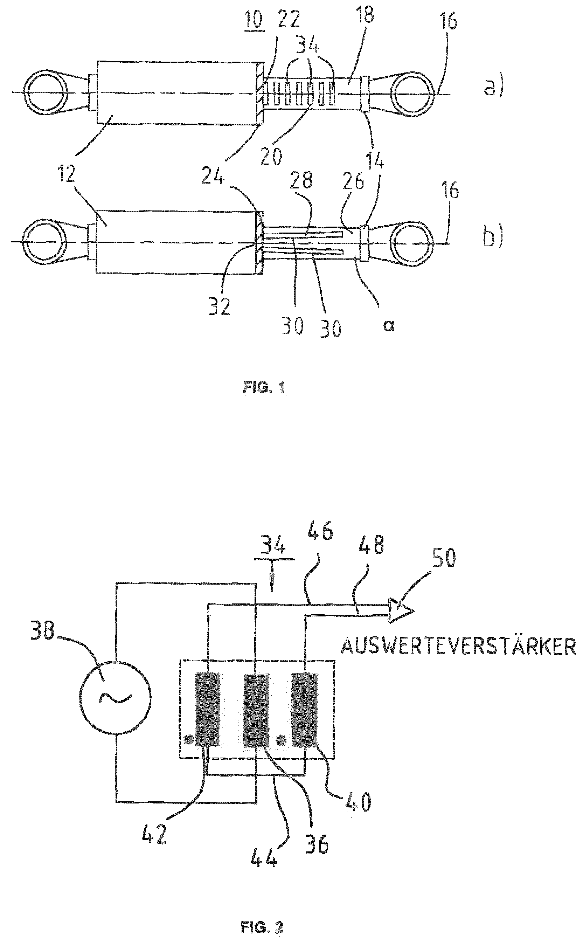

Fig. 1a zeigt einen hydraulischen Antrieb 10 in Draufsicht, umfassend einen Hydraulikzylinder 12, in dem eine Kolbenstange 14 entlang einer Längsachse 16 beweglich angeordnet ist. Auf einer metallischen Oberfläche 18 der Kolbenstange 14 ist eine erste magnetisch abtastbare Struktur 20 in Form von äquidistanten Messstreifen 34 eingebracht. Diese werden mittels eines ersten Magnetflusssensors 22 erfasst, der stationär an dem Hydraulikzylinder 12 vorzugsweise in einem stirnseitigen Sensorring 24 angeordnet ist.

Zur absoluten Positionsbestimmung ist auf einer Unterseite 26 der zylinderförmigen Kolbenstange 14 eine zweite magnetisch abtastbare Struktur 28 vorgesehen, welche einen ersten und zweiten Messstreifen 30 umfasst, die sich entlang der Längsachse 16 erstrecken vorzugsweise V-förmig angeordnet sind. Die Messstreifen 30 erstrecken sich in einem Winkel α zu der Längsachse 16, mit α im Bereich von 0,2°≤ α ≤ 20°, vorzugsweise α = 1° bis 2°.

Die erste magnetisch abtastbare Struktur 34, welche äquidistant angeordnete Einzelmessstreifen 20 umfasst, wird durch thermische Gefügeänderung z. B. durch selektives Härten der aus Stahl bestehenden Oberfläche 18 der Kolbenstange 14 erzeugt. Die Gefügeänderung kann durch selektives Laserhärten oder ähnliche Verfahren wie Elektronenstrahlhärten oder selektives Weichglühen erzeugt werden. Eine weitere Möglichkeit besteht darin, Mikrogräben in die Oberfläche der Kolbenstange 14 oder durch andere strukturverändernde Maßnahmen einzubringen und diese mit einem Material zu füllen, welches gegenüber dem Material der Oberfläche eine abweichende Permeabilität bzw. magnetische Eigenschaft aufweist. Nach dem Einbringen der Messstreifen 34, 30 in das Kolbenmaterial wird die Oberfläche 18, 26 der Kolbenstange 14 geschliffen und oberflächenvergütet, z. B. mit Chrom oder Nickelchrom.

Die Messstreifen 30 der zweiten Struktur 28 werden mittels eines zweiten Magnetflusssensors 32 erfasst.

Gemäß der Erfindung werden die magnetisch abtastbaren Strukturen 34, 30 mittels eines differentiellen Messverfahrens erfasst. Dies hat den Vorteil, dass dadurch die Genauigkeit erhöht und Störeffekte eliminiert werden können.

Der Magnetflusssensor 22 bzw. 32 zur Durchführung des Verfahrens ist rein schematisch in Fig. 2 dargestellt. Gemäß der Erfindung ist der Magnetflusssensor 22, 32 als Differentialtransformator 34 ausgebildet. Der Differentialtransformator 34 umfasst eine Primärwicklung 36, die mit einem Wechselspannungsgenerator 38 verbunden ist und mit Wechselspannung, vorzugsweise einem Sinus-Signal erregt wird.

Des Weiteren umfasst der Differentialtransformator 34 magnetisch mit der Primärwicklung 26 gekoppelte äußere Sekundärwicklungen 40, 42, die über eine Verbindung 44 phasengleich verschaltet sind. Ausgänge 46, 48 der jeweiligen Sekundärwicklungen 40, 42 sind mit einer Auswerteschaltung 50 wie Auswerteverstärker verbunden.

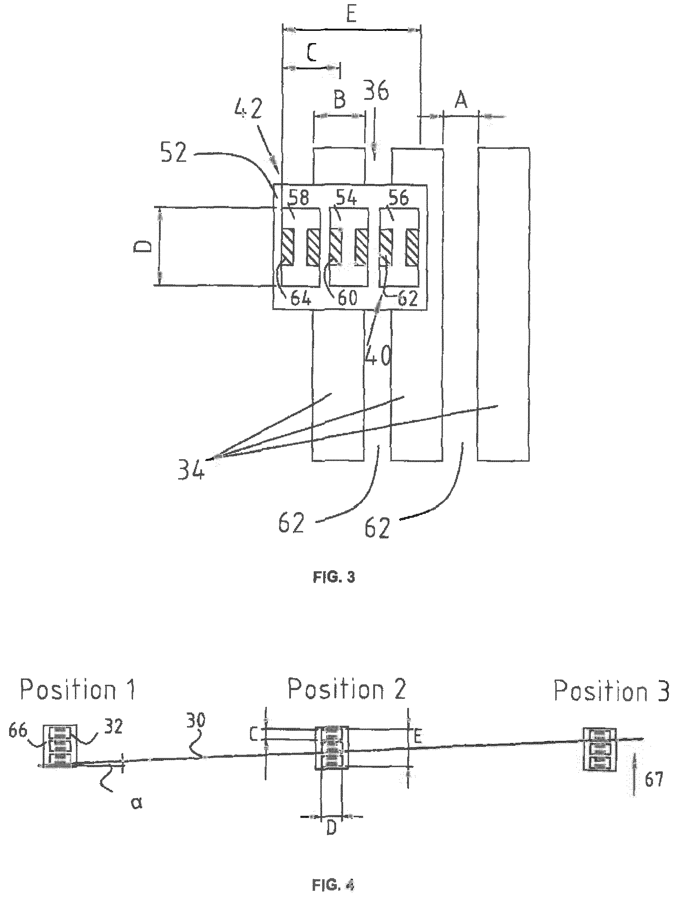

Fig. 3 zeigt eine schematische Draufsicht eines Sensorkopfes 52 des Differentialtransformators 36, 40, 42 in Bezug zu den Messstreifen 34 gemäß Fig. 1a. Die Messstreifen 34 sind in einem äquidistanten Abstand A in Längsrichtung zur Bildung eines Maßstabs angeordnet, wobei der Abstand A im Bereich von 1 mm ≤ A ≤ 20 mm, vorzugsweise A = 5 mm liegt. Die Messstreifen 34 weisen eine Breite B im Bereich von 0,5 mm ≤ B ≤ 10 mm, vorzugsweise B = 5 mm auf.

In dem hier dargestellten Ausführungsbeispiel sind die Primärwicklung 36 und die Sekundärwicklungen 40, 42 als SMD (Surface Mounted Device) - Induktivitäten ausgebildet. Jede der SMD-Induktivitäten 36, 40, 42 umfasst einen Magnetkern 54, 56, 58, der jeweils eine Spule 60, 62, 64 trägt. Diese sind auf einem Träger in einer Ebene angeordnet.

Dabei sind die Magnetkerne 54, 56, 58 mit ihren magnetischen Achsen parallel zueinander und in Bewegungsrichtung der Kolbenstange 14 dicht hintereinander angeordnet, wobei die Transformatorkerne 54, 56, 58 parallel zu den Messstreifen 34 ausgerichtet sind.

Des Weiteren ist vorgesehen, das die SMD-Induktivitäten 36, 40, 42 eine Breite C aufweisen, die im Bereich von 0,5 mm ≤ C ≤ 10 mm liegt. Ferner weisen die SMD-Induktivitäten eine Länge D auf, die im Bereich von 1 mm ≤ D ≤ 20 mm liegt.

Wie bereits zuvor erläutert, umfasst der Differentialtransformator 34 die Primärwicklung 36 sowie die Sekundärwicklungen 40, 42, wobei letztere gegenphasig oder phasengleich entsprechend des angewandten Auswerteverfahrens (differenziell oder nicht differenziell) geschaltet sind. Dadurch werden die Gleichanteile der Spannungen an den Anschlüssen 46, 48 eliminiert. Die resultierende Spannung ist genau dann Null, wenn beideWicklungen und die gesamte Konstruktion symmetrisch aufgebaut sind. Wird diese Symmetrie z. B. durch Relativbewegungen des Magnetflusssensors 22, 32 zu den Messstreifen 34, 30 verändert, so entsteht eine Ausgangsspannung, deren Amplitude die größe der Asymmetrie angibt. An der Primärwicklung 36 liegt eine Wechselspannung mit konstanter Amplitude und konstanter Frequenz an, die in der Regel eine Frequenz von 50 Hz bis 500 kHz hat.

Bei der Relativbewegung der Kolbenstange 14 zu dem fest angeordneten Magnetflusssensor 22, 32 entlang der magnetisch abtastbaren Messstreifen werden die Kopplungsfaktoren zwischen den Wicklungen verändert. Befindet sich z. B. die Primärwicklung 36 unmittelbar über einem Messstreifen 34, so ist die Anordnung symmetrisch, die Spannungen von Sekundärwicklungen heben sich auf und es entsteht kein Ausgangssignal. Sobald die Kolbenstange 14 verschoben wird, liegt eine ungleiche magnetische Kopplung vor, wodurch eine Ausgangsspannung an den Sekundärwicklungen erzeugt wird. Durch eine Korrelation mit der Erregerspannung lässt sich ein Richtungssignal erzeugen. Das Ausgangssignal ist sinusförmig und sehr stabil, so dass eine sehr hohe Auflösung realisiert werden kann.

Fig. 3 zeigt die Sensorkopfanordnung 22, 32 nach dem Prinzip des in Fig. 2 dargestellten Differentialtransformators 34 über den selektiv gehärteten Messstreifen 34. Ein Messstreifen 34 und ein dazugehöriger Leerraum 62 bilden jeweils einen Sektor.

Mit dem bisher beschriebenen Verfahren ist jedoch eine Absolutwertmessung nicht realisierbar.

Gemäß der Erfindung wird zur absoluten Wegmessung ein sogenannter Sektorpointer vorgeschlagen. Dieser wird durch die auf der Unterseite 26 des Kolbens 14 angeordnete zweite magnetisch abtastbare Strukutr 28 realisiert. Diese umfasst zwei entlang der Längsachse 16 des Kolbens 14 schräg verlaufende Messstreifen 30. Der Messstreifen 30 ist zusammen mit dem zweiten Magnetflusssensor 32 in verschiedenen Positionen in Fig. 4 dargestellt.

Im Vergleich zu dem Wegmesssystem gemäß Fig. 3 weist das Wegmesssystem gemäß Fig. 4 eine geringere Auflösung, jedoch einen erheblich größeren Messbereich auf. Der Magnetflusssensor 32 weist einen Aufbau auf, der dem Magnetflusssensor 22 entspricht. Allerdings ist eine Sensorfläche 66 des Magnetflusssensors 32 quer zu der Längsachse 16 angeordnet, so dass bei einer linearen Bewegung der Kolbenstange 14 entlang des Magnetflusssensors 32 z. B. der Messstreifen 30 in Richtung des Pfeils 68 den Sensorkopf 66 quer überfährt, wobei aufgrund der stetigen Kopplungsänderungen ein sinusförmiges Ausgangssignal erzeugt wird.

In Kombination bilden die in Fig. 3 und Fig. 4 dargestellten Messsysteme ein hochpräzises, absolut messendes Wegsystem.

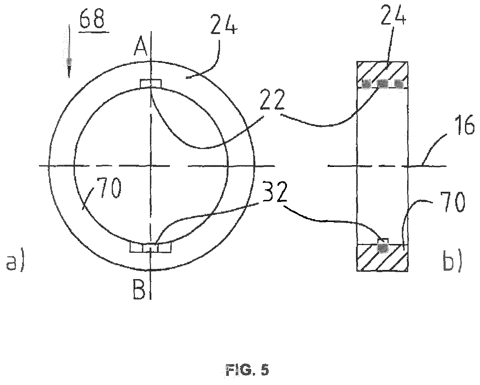

Fig. 5a zeigt einen Sensorring 68 zur Aufnahme der Sensoren 22, 32 in Vorderansicht, während Fig. 5b den Sensorring 68 in Schnittdarstellung zeigt. Der Magnetflusssensor 32 umfasst die drei SMD-Induktivitäten, die in Richtung der Längsachse 16 hintereinander angeordnet sind, während der Magnetflusssensor 32 sich in Umfangsrichtung entlang eines Innenrandes 70 des Sensorrings 68 erstreckt. Durch den Sensorring 68 wird die Möglichkeit eröffnet, das Antriebssystem gemäß Fig. 1 auf einfache Weise, auch nachträglich, mit einem Wegmesssystem auszustatten, wobei der Sensorring 24 an einer Stirnseite des Zylinders 12 koaxial zu der Kolbenstange 14 fixiert ist.

## Patentansprüche

1. Verfahren zur Bestimmung einer Position eines ersten Bauteils (14) in Bezug zu einem zweiten Bauteil (12), wobei zumindest eine auf einer Oberfläche (18) des ersten Bauteils (14) ausgebildete erste magnetisch abtastbare Struktur (34) mittels zumindest eines mit dem zweiten Bauteil (12) verbundenen ersten Magnetflusssensors (22) bei einer Relativbewegung zwischen dem ersten Bauteil (14) und dem ersten Magnetflusssensor (22) erfasst wird, wobei zur Durchführung eines differenziellen Messverfahrens als Magnetflusssensor (22) ein Differentialtransformator verwendet wird mit einer Primärwicklung (36) und zwei Sekundärwicklungen (40, 42), welche so verschaltet sind, dass sich als ihr jeweiliges Ausgangssignal unmittelbar die Differenz der Signale der zugehörigen Sekundärwicklungen ergibt, wobei die von der Primärwicklung in den Sekundärwicklungen erzeugten Spannungen sich bei symmetrischer magnetischer Kopplung der Wicklung gegenseitig aufheben, wobei die erste magnetisch abtastbare Struktur als magnetisch abtastbare Bereiche einer metallischen Oberfläche mit abweichender Permeabilität oder magnetischer Eigenschaft derart ausgebildet ist, dass sich die magnetische Kopplung der Wicklungen bei der Relativbewegung des ersten Differentialtransformators entlang der magnetisch abtastbaren Struktur verändert, wodurch am Ausgang des ersten Differentialtransformators ein kontinuierliches inkrementelles Signal anliegt, dessen Größe ein Maß für die Asymmetrie ist und aus dem die relative Position des ersten Bauteils bestimmt wird,
**dadurch gekennzeichnet,**
**dass** eine auf der Oberfläche (18) des ersten Bauteils (14) angeordnete zweite magnetisch abtastbare Struktur (28) mittels zumindest eines mit dem zweiten Bauteil (14) verbundenen zweiten Differentialtransformators (32) erfasst wird und dass aus der kontinuierlichen, inkrementellen Signalfolge des ersten Differentialtransformators (22) und einem kontinuierlichen, stetigen Ausgangssignal des zweiten Differentialtransformators (32) die absolute Position des ersten Bauteils (14) bestimmt wird.

2. Verfahren nach Anspruch 1,
**dadurch gekennzeichnet,**
**dass** als erste magnetisch abtastbare Struktur (34) magnetisch abtastbare Messstreifen (20) verwendet werden, welche in Form von Inkrementen eines Maßstabes vorzugsweise äquidistant entlang Längsachse (16) des ersten Bauteils (14) quer zu der Längsachse (16) verlaufen und dass bei der Relativbewegung der Messstreifen (22) ein kontinuierliches Sinus-Signal oder Cosinus-Signal erzeugt wird.

3. Verfahren nach Anspruch 1,
**dadurch gekennzeichnet,**
**dass** als zweite magnetisch abtastbare Struktur (28) zwei magnetisch abtastbare Messstreifen (30) verwendet werden, welche entlang der Längsachse (16) V-förmig und symmetrisch zu der Längsachse (16) des Bauteils (14) verlaufen.

4. Verfahren nach Anspruch 3,
**dadurch gekennzeichnet,**
**dass** die Messstreifen (30) bei linearer Bewegung des Bauteils (14) quer zu einer Sensorfläche (64) des zweiten Magnetflusssensors (32) entlang der Sensorfläche bewegt werden, so dass in dem zweiten Magnetflusssensor (32) das von der Position des ersten Bauteils (14) abhängige kontinuierliche, stetige Ausgangssignal erzeugt wird.

5. Verfahren nach zumindest einem der vorhergehenden Ansprüche,
**dadurch gekennzeichnet,**
**dass** zumindest zwei der ersten Magnetflusssensoren (22) räumlich so versetzt zueinander angeordnet werden, dass ein vorderer erster Magnetflusssensor bei linearer Bewegung des Bauteils (14) ein Sinus-Signal und ein hinterer erster Magnetflusssensor (22) ein Cosinus-Signal erzeugt.

6. Anordnung zur Bestimmung einer Position eines ersten Bauteils (14) in Bezug zu einem zweiten Bauteil (12), umfassend zumindest einen mit dem zweiten Bauteil (12) verbundenen ersten Magnetflusssensor (22) zur Erfassung einer auf einer Oberfläche (18) des ersten Bauteils (14) ausgebildeten ersten magnetisch abtastbaren Struktur (20) bei einer Relativbewegung zwischen dem ersten Bauteil (14) und dem ersten Magnetflusssensor (22), wobei der erste Magnetflusssensor (22) als Differentialtransformator mit einer Primärwicklung (36) und zwei Sekundärwicklungen (40, 42) ausgebildet ist, welche so verschaltet sind, dass sich als ihr jeweiliges Ausgangssignal unmittelbar die Differenz der Signale der zugehörigen Sekundärwicklungen ergibt, so dass die von der Primärwicklung in den Sekundärwicklungen erzeugten Spannungen sich bei symmetrischer magnetischer Kopplung der Wicklung gegenseitig aufheben, wobei die magnetisch abtastbare Struktur an der metallischen Oberfläche des ersten Bauteils in Form von Bereichen mit unterschiedlicher Permeabilität oder magnetischer Eigenschaft derart ausgebildet ist, dass sich die magnetische Kopplung der Wicklungen bei der Relativbewegung des Differentialtransformators entlang der Messstruktur verändert, wodurch am Ausgang des ersten Differentialtransformators ein kontinuierliches Signal anliegt, dessen Größe ein Maß für die Unsymmetrie ist und aus dem Verlauf dieses kontinuierlichen, inkrementellen Signals die relative Position des ersten Bauteils bestimmbar ist,
**dadurch gekennzeichnet,**
**dass** das zweite Bauteil (12) zur Bestimmung der absoluten Position des ersten Bauteils (14) zumindest einen zweiten als Differentialtransformator ausgebildeten Magnetflusssensor (32) aufweist, dass das erste Bauteil (14) zumindest eine entlang einer Längsachse (16) des ersten Bauteils (14) verlaufende zweite magnetisch abtastbare Struktur (28) aufweist, welche durch den zweiten Differentialtransformator (32) abtastbar ist, wobei der zweite Differentialtransformator (32) bei Relativbewegung entlang der zweiten magnetisch abtrastbaren Struktur (28) ein kontinuierliches, stetiges Ausgangssignal erzeugt, wobei mit Hilfe des stetigen Ausgangssignals des zweiten Differentialtransformators die absolute Position des ersten Bauteils bestimmbar ist.

7. Anordnung nach Anspruch 6,
**dadurch gekennzeichnet,**
**dass** die erste magnetisch abtastbare Struktur (20) quer zu einer Längsachse (16) des ersten Bauteils (14) verlaufende Messstreifen (34) umfasst, welche entlang der Längsachse (16) vorzugsweise äquidistant hintereinander angeordnet sind.

8. Anordnung nach Anspruch 7,
**dadurch gekennzeichnet,**
**dass** jeder der Messstreifen (20) eine Breite B im Bereich 0,5 mm bis 10 mm, vorzugsweise B = 5 mm aufweist und dass die Messstreifen (34) einen Abstand A voneinander aufweisen, der im Bereich 1 mm ≤ A ≤ 20 mm, vorzugsweise A = 5 mm liegt.

9. Anordnung nach Anspruch 6,
**dadurch gekennzeichnet,**
**dass** die zweite magnetisch abtastbare Struktur (28) zwei, zueinander V-förmig entlang der Längsachse (16) verlaufende Messstreifen (30) umfasst, die bei linearer Bewegung des ersten Bauteils (14) eine Sensorfläche (84) des zweiten Magnetflusssensors (32) überqueren.

10. Anordnung nach Anspruch 6,
**dadurch gekennzeichnet,**
**dass** Primär- und Sekundärwicklungen (36, 40, 42) des Differenzialtransformators, (22, 32) als in einer Ebene angeordnete Induktivitäten (36, 40, 42) ausgebildet und zur Bildung einer Sensorfläche (64, 66) auf einem Träger derart nebeneinander angeordnet sind, dass deren magnetische Achsen parallel zueinander verlaufen und/oder dass die Sensorfläche (64, 66) eine Gesamterstreckung E in Bewegungsrichtung der magnetischen Struktur (34) aufweist, die im Bereich 1,5 mm ≤ E ≤ 30 mm liegt.

11. Anordnung nach Anspruch 10,
**dadurch gekennzeichnet,**
**dass** die Induktivität (36, 40, 42) als SMD (Surface Mounted Device)-Induktivität oder Miniatur-Induktivität ausgebildet sind und/oder dass die Induktivitäten (36, 40, 42) jeweils eine Erstreckung C in Bewegungsrichtung der magnetischen Struktur (34) aufweisen, die im Bereich 1 mm ≤ C ≤ 20 mm liegt und eine Länge D, die im Bereich 1 mm ≤ D ≤ 20 mm liegt.

12. Anordnung nach zumindest einem der Ansprüche 6 bis 11,
**dadurch gekennzeichnet,**
**dass** die Anordnung ein hydraulischer, elektrischer oder pneumatischer Antrieb (10) ist, wobei das erste Bauteil (14) als eine Kolbenstange und wobei das zweite Bauteil (12) als ein hydraulischer, elektrischer oder pneumatischer Zylinder ausgebildet ist, in dem die Kolbenstange längsbeweglich verschiebbar ist.

13. Anordnung nach zumindest einem der Ansprüche 6 bis 12,
**dadurch gekennzeichnet,**
**dass** der Magnetflusssensor (22, 32) an einem innenliegenden Rand (70) eines an dem Hydraulik- oder Pneumatikzylinder (12) angeordneten Sensorhalters (24) angrenzend an die Oberfläche (18) der Kolbenstange (14) zum Erfassen der Messstreifenanordnung (20, 28) angeordnet ist, wobei der Sensorhalter (24) vorzugsweise als ein stirnseitig mit dem Zylinder (12) verbundener Sensorring ausgebildet ist.

14. Anordnung nach zumindest einem der vorhergehenden Ansprüche,
**dadurch gekennzeichnet,**
**dass** die erste und zweite magnetisch abtastbare Messstreifenanordnung (30,34) auf diametral gegenüberliegenden Oberflächen (18, 26) der Kolbenstange (14) ausgebildet sind und dass der erste und zweite Magnetflusssensor (22, 32) an diametral gegenüberliegenden Positionen des stirnseitig umlaufenden Sensorhalters (24) angeordnet sind und/oder dass erster und zweiter Magnetflusssensor (22, 32) jeweils in einer Aussparung einer Innenfläche (70) des Sensorhalters (24) angeordnet sind.

15. Anordnung nach zumindest einem der vorhergehenden Ansprüche,
**dadurch gekennzeichnet,**
**dass** mehrere erste oder zweite Magnetflusssensoren (22, 32) vorgesehen sind, die räumlich so versetzt sind, dass bei linearer Bewegung des ersten Bauteils ein Sinus- und ein Cosinus-Signal als Ausgangssignal erzeugt wird.

## Claims

1. A method for determining a position of a first component (14) in relation to a second component (12), wherein at least one first magnetically scannable structure (34) formed on a surface (18) of the first component (14) is detected by means of at least one first magnetic flux sensor (22) connected to the second component (12) during a relative movement between the first component (14) and the first magnetic flux sensor (22), wherein to execute a differential measurement method, a differential transformer is used as magnetic flux sensor (22), said transformer comprising a primary winding (36) and two secondary windings (40, 42), which are interconnected such that the difference between the signals of the related secondary windings results directly in their respective output signal, wherein the voltages generated by the primary winding in the secondary windings are mutually canceled out when the windings are symmetrically magnetically coupled, wherein the first magnetically scannable structure is embodied as magnetically scannable regions of a metallic surface that have a different permeability or magnetic property, such that the magnetic coupling of the windings changes during the relative movement of the first differential transformer along the magnetically scannable structure, whereby a continuous incremental signal is present at the output of the first differential transformer, the magnitude of which is a measure of asymmetry, and from which the relative position of the first component is determined,
**characterized in that**
a second magnetically scannable structure (28) arranged on the surface (28) of the first component (14) is detected by means of at least one second differential transformer (32) connected to the second component (14), and **in that** the absolute position of the first component (14) is determined from the continuous, incremental signal sequence of the first differential transformer (22) and a continuous, steady output signal of the second differential transformer (32).

2. The method according to claim 1,
**characterized in that**
magnetically scannable measurement strips (20) which extend in the form of increments of a scale, preferably equidistant along the longitudinal axis (16) of the first component (14), transversely to the longitudinal axis (16), are used as the first magnetically scannable structure (34), and **in that** a continuous sine signal or cosine signal is generated with a relative movement of the measurement strips (22).

3. The method according to claim 1,
**characterized in that**
two magnetically scannable measurement strips (30) which extend in a V-shave along the longitudinal axis (16) and symmetrically to the longitudinal axis (16) of the component (14), are used as the second magnetically scannable structure (28).

4. The method according to claim 3,
**characterized in that**
during a linear movement of the component (14), the measurement strips (30) are moved transversely to a sensor surface (64) of the second magnetic flux sensor (32) along the sensor surface, so that the continuous, steady output signal that is dependent on the position of the first component (14) is generated in the second magnetic flux sensor (32).

5. The method according to at least one of the preceding claims,
**characterized in that**
at least two of the first magnetic flux sensors (22) are arranged spatially offset from one another such that, during a linear movement of the component (14), a front first magnetic flux sensor generates a sine signal and a rear first magnetic flux sensor (22) generates a cosine signal.

6. An arrangement for determining a position of a first component (14) in relation to a second component (12), comprising at least one first magnetic flux sensor (22), connected to the second component (12), for detecting a first magnetically scannable structure (20) formed on a surface (18) of the first component (14) during a relative movement between the first component (14) and the first magnetic flux sensor (22), wherein the first magnetic flux sensor (22) is embodied as a differential transformer having a primary winding (36) and two secondary windings (40, 42) which are interconnected such that the difference between the signals of the related secondary windings results directly in their respective output signal, so that the voltages generated by the primary winding in the secondary windings are mutually canceled out when the windings are symmetrically magnetically coupled, wherein the magnetically scannable structure is formed on the metallic surface of the first component in the form of regions of different permeability or magnetic property, such that the magnetic coupling of the windings changes during a relative movement of the differential transformer along the measurement structure, whereby a continuous signal is present at the output of the first differential transformer, the magnitude of which is a measurement of asymmetry, and the relative position of the first component can be determined from the course of this continuous, incremental signal, **characterized in that**
the second component (12) has at least one second magnetic flux sensor (32), embodied as a differential transformer, for determining the absolute position of the first component (14), **in that** the first component (14) has at least one second magnetically scannable structure (28) extending along a longitudinal axis (16) of the first component (14), which can be scanned by the second differential transformer (32), wherein the second differential transformer (32) generates a continuous, steady output signal during a relative movement along the second magnetically scannable structure (28), wherein the absolute position of the first component can be determined with the help of the steady output signal of the second differential transformer.

7. The arrangement according to claim 6,
**characterized in that**
the first magnetically scannable structure (20) comprises measurement strips (34) that extend transversely to a longitudinal axis (16) of the first component (14) and are preferably arranged equidistant, one behind the other, along the longitudinal axis (16).

8. The arrangement according to claim 7,
**characterized in that**
the width B of each of the measurement strips (20) ranges from 0.5 mm to 10 mm, preferably with B = 5 mm, and **in that** the measurement strips (34) are spaced a distance A from one another, which distance is within the range of 1 mm ≤ A ≤ 20 mm, preferably with A = 5 mm.

9. The arrangement according to claim 6,
**characterized in that**
the second magnetically scannable structure (28) comprises two measurement strips (30) extending in a V-shape relative to one another along the longitudinal axis (16), which strips traverse a sensor surface (84) of the second magnetic flux sensor (32) during a linear movement of the first component (14).

10. The arrangement according to claim 6
**characterized in that**
primary and secondary windings (36, 40, 42) of the differential transformer (22, 32) are embodied as inductors (36, 40, 42), which are arranged in a single plane and are arranged adjacent to one another on a substrate so as to form a sensor surface (64, 66) such that the magnetic axes thereof extend parallel with one another and/or such that the sensor surface (64, 66) has a total extension E in the direction of movement of the magnetic structure (34) that is within the range of 1.5 mm ≤ E ≤ 30 mm.

11. The arrangement according to claim 10,
**characterized in that**
the inductor (36, 40, 42) are embodied as an SMD (surface mounted device) inductor or miniature inductor and/or **in that** each of the inductors (36, 40, 42) has an extension C in the direction of movement of the magnetic structure (34) that is within the range of 1 mm ≤ C ≤ 20 mm, and has a length D that is within the range of 1 mm ≤ D ≤ 20 mm.

12. The arrangement according to at least one of the claims 6 to 11,
**characterized in that**
the arrangement is a hydraulic, electric or pneumatic drive (10), wherein the first component (14) is embodied as a piston rod and wherein the second component (12) is embodied as a hydraulic, electric or pneumatic cylinder within which the piston rod can be longitudinally displaced.

13. The arrangement according to at least one of the claims 6 to 12,
**characterized in that**
the magnetic flux sensor (22, 32) is arranged on an inner edge (70) of a sensor holder (24) arranged on the hydraulic or pneumatic cylinder (12), bordering the surface (18) of the piston rod (14) for detecting the measurement strip arrangement (20, 28), wherein the sensor holder (24) is preferably embodied as a sensor ring that is attached to the end face of the cylinder (12).

14. The arrangement according to at least one of the preceding claims,
**characterized in that**
the first and second magnetically scannable measurement strip arrangements (30, 34) are formed on diametrically opposite surfaces (18, 26) of the piston rod (14) and **in that** the first and second magnetic flux sensors (22, 32) are arranged in diametrically opposite positions of the sensor holder (24) encompassing the end face and/or **in that** the first and second magnetic flux sensors (22, 32) are each arranged in a recess in an inner surface (70) of the sensor holder (24).

15. The arrangement according to at least one of the preceding claims,
**characterized in that**
a plurality of first or second magnetic flux sensors (22, 32) is provided, which are offset from one another spatially such that during a linear movement of the first component, a sine signal and a cosine signal are generated as output signals.

## Revendications

1. Procédé destiné à déterminer une position d'un premier composant (14) par rapport à un deuxième composant (12), sachant qu'au moins une première structure (34) formée sur une surface (18) du premier composant (14), et explorable par balayage magnétique, est détectée par au moins un premier capteur de flux magnétique (22) relié au deuxième composant (12) lors d'un mouvement relatif entre le premier composant (14) et le premier capteur de flux magnétique (22), que pour réaliser un procédé de mesure différentiel est utilisé en tant que capteur de flux magnétique (22) un transformateur différentiel avec un enroulement primaire (36) et deux enroulements secondaires (40, 42), lesquels sont câblés de sorte que leurs signaux de sortie respectifs sont directement la différence des signaux des enroulements secondaires associés, sachant que les tensions générées par l'enroulement primaire dans les enroulements secondaires se neutralisent en présence d'un couplage magnétique symétrique de l'enroulement, que la première structure explorable par balayage magnétique est formée en tant que zones explorables par balayage magnétique d'une surface métallique, avec perméabilité ou propriété magnétique différente, de manière telle que le couplage magnétique des enroulements se modifie lors du mouvement relatif du premier transformateur différentiel le long de la structure explorable par balayage magnétique, de sorte qu'à la sortie du premier transformateur différentiel est appliqué un signal incrémentiel continu dont la grandeur est une mesure de l'asymétrie et à partir duquel est déterminée la position relative du premier composant,
**caractérisé en ce**
**qu'**une deuxième structure explorable par balayage magnétique (28) disposée sur la surface (18) du premier composant (14) est détectée par au moins un deuxième transformateur différentiel (32) relié au deuxième composant (14) et qu'à partir de la séquence de signaux incrémentielle continue du premier transformateur différentiel (22) et d'un signal de sortie continu, régulier, du deuxième transformateur différentiel (32) est déterminée la position absolue du premier composant (14).

2. Procédé selon la revendication 1,
**caractérisé en ce**
**qu'**en tant que première structure explorable par balayage magnétique (34) sont utilisées des bandes de mesure explorables par balayage magnétique (20), lesquelles s'étendent sous forme d'incréments d'une échelle graduée, de préférence de manière équidistante, le long de l'axe longitudinal (16) du premier composant (14) transversalement à l'axe longitudinal (16), et que lors du mouvement relatif des bandes de mesure (22) est généré un signal sinusoïdal ou cosinusoïdal continu.

3. Procédé selon la revendication 1,
**caractérisé en ce**
**qu'**en tant que deuxième structure explorable par balayage magnétique (28) sont utilisées deux bandes de mesure explorables par balayage magnétique (30), lesquelles s'étendent en V le long de l'axe longitudinal (16) et symétriquement à l'axe longitudinal (16) du composant (14).

4. Procédé selon la revendication 3,
**caractérisé en ce**
**que** lors d'un mouvement linéaire du composant (14), les bandes de mesure (30) sont déplacées transversalement à une zone de détection (64) du deuxième capteur de flux magnétique (32) le long de la zone de détection, de sorte qu'est généré dans le deuxième capteur de flux magnétique (32) le signal de sortie continu, régulier, dépendant de la position du premier composant (14).

5. Procédé selon au moins une des revendications précédentes,
**caractérisé en ce**
**qu'**au moins deux des premiers capteurs de flux magnétique (22) sont décalés dans l'espace l'un pas rapport à l'autre de manière telle que lors d'un mouvement linéaire du composant (14), un premier capteur de flux magnétique avant génère un signal sinusoïdal et un premier capteur de flux magnétique arrière (22) génère un signal cosinusoïdal.

6. Dispositif destiné à déterminer une position d'un premier composant (14) par rapport à un deuxième composant (12), comprenant au moins un premier capteur de flux magnétique (22) relié au deuxième composant (12) pour détecter une première structure explorable par balayage magnétique (20) formée sur une surface (18) du premier composant (14) lors d'un mouvement relatif entre le premier composant (14) et le premier capteur de flux magnétique (22), sachant que le premier capteur de flux magnétique (22) est conçu en tant que transformateur différentiel avec un enroulement primaire (36) et deux enroulements secondaires (40, 42), lesquels sont câblés de sorte que leurs signaux de sortie respectifs sont directement la différence des signaux des enroulements secondaires associés, de sorte que les tensions générées par l'enroulement primaire dans les enroulements secondaires se neutralisent en présence d'un couplage magnétique symétrique de l'enroulement, sachant que la structure explorable par balayage magnétique sur la surface métallique du premier composant est conçue sous forme de zones avec perméabilité ou propriété magnétique différente, de manière telle que le couplage magnétique des enroulements se modifie lors du mouvement relatif du transformateur différentiel le long de la structure de mesure, de sorte qu'à la sortie du premier transformateur différentiel est appliqué un signal continu, dont la grandeur est une mesure de l'asymétrie, et qu'à partir de l'allure de ce signal continu, incrémentiel, peut être déterminée la position relative du premier composant,
**caractérisé en ce**
**que** pour déterminer la position absolue du premier composant (14), le deuxième composant (12) présente au moins un deuxième capteur de flux magnétique (32) conçu en tant que transformateur différentiel, que le premier composant (14) présente au moins une deuxième structure explorable par balayage magnétique (28) s'étendant le long d'un axe longitudinal (16) du premier composant (14), ladite deuxième structure étant explorable par le deuxième transformateur différentiel (32), sachant que lors d'un mouvement relatif le long de la deuxième structure explorable par balayage magnétique (28), le deuxième transformateur différentiel (32) génère un signal de sortie continu, régulier, et qu'à l'aide du signal de sortie régulier du deuxième transformateur différentiel peut être déterminée la position absolue du premier composant.

7. Dispositif selon la revendication 6,
**caractérisé en ce**
**que** la première structure explorable par balayage magnétique (20) comprend des bandes de mesure (34) s'étendant transversalement à un axe longitudinal (16) du premier composant (14), lesquelles sont disposées le long de l'axe longitudinal (16) de préférence équidistantes les unes derrière les autres.

8. Dispositif selon la revendication 7,
**caractérisé en ce**
**que** chaque bande de mesure (20) présente une largeur B dans la plage de 0,5 mm à 10 mm, de préférence B = 5 mm, et que la distance A entre les bandes de mesure (34) est telle que 1 mm ≤ A ≤ 20 mm, de préférence A = 5 mm.

9. Dispositif selon la revendication 6,
**caractérisé en ce**
**que** la deuxième structure explorable par balayage magnétique (28) comprend deux bandes de mesure (30) s'étendant en V l'une par rapport à l'autre le long de l'axe longitudinal (16), et qui lors d'un mouvement linéaire du premier composant (14) traversent une zone de détection (84) du deuxième capteur de flux magnétique (32).

10. Dispositif selon la revendication 6,
**caractérisé en ce**
**que** les enroulements primaires et secondaires (36, 40, 42) du transformateur différentiel (22, 32) sont conçus en tant qu'inductances (36, 40, 42) disposées dans un plan et que pour former une zone de détection (64, 66), elles sont agencées côte à côte sur un support de manière telle que leurs axes magnétiques sont parallèles entre eux, et/ou que la zone de détection (64, 66) présente dans la direction de déplacement de la structure magnétique (34) une extension totale E telle que 1,5 mm ≤ E ≤ 30 mm.

11. Dispositif selon la revendication 10,
**caractérisé en ce**
**que** les inductances (36, 40, 42) sont conçues en tant qu'inductances CMD (Composant Monté en Surface) ou qu'inductances miniatures et/ou que les inductances (36, 40, 42) présentent respectivement dans la direction de déplacement de la structure magnétique (34) une extension C telle que 1 mm ≤ C ≤ 20 mm et une longueur D telle que 1 mm ≤ D ≤ 20 mm.

12. Dispositif selon au moins une des revendications 6 bis 11,
**caractérisé en ce**
**que** le dispositif est un entraînement hydraulique, électrique ou pneumatique (10), sachant que le premier composant (14) est conçu en tant que tige de piston et le deuxième composant (12) en tant vérin hydraulique, électrique ou pneumatique, dans lequel la tige de piston est mobile selon un mouvement longitudinal.

13. Dispositif selon au moins une des revendications 6 bis 12,
**caractérisé en ce**
**que** le capteur de flux magnétique (22, 32) est disposé sur un bord intérieur (70) d'un support de capteur (24) placé sur le vérin hydraulique ou pneumatique (12) jouxtant la surface (18) de la tige de piston (14) afin de détecter l'arrangement de bandes de mesure (20, 28), le support de capteur (24) étant de préférence conçu en tant qu'anneau de capteur relié frontalement au vérin (12).

14. Dispositif selon au moins une des revendications précédentes,
**caractérisé en ce**
**que** le premier et le deuxième arrangements de bandes de mesure (30, 34) explorables par balayage magnétique sont formés sur des surfaces (18, 26) diamétralement opposées de la tige de piston (14) et que le premier et le deuxième capteurs de flux magnétique (22, 32) occupent des positions diamétralement opposées du support de capteur (24) enveloppant frontalement, et/ou que le premier et le deuxième capteurs de flux magnétique (22, 32) sont respectivement disposés dans un évidement d'un surface intérieure (70) du support de capteur (24).

15. Dispositif selon au moins une des revendications précédentes,
**caractérisé en ce**
**que** sont prévus plusieurs premiers ou deuxièmes capteurs de flux magnétique (22, 32) qui sont décalés dans l'espace de manière telle que lors d'un mouvement linéaire du premier composant sont générés un signal sinusoïdal et un signal cosinusoïdal en tant que signaux de sortie.
